(19) Europäisches Patentamt / European Patent Office / Office européen des brevets

(11) **EP 3 400 618 B1**

(12) **FASCICULE DE BREVET EUROPEEN**

(45) Date de publication et mention
de la délivrance du brevet:
**13.12.2023  Bulletin 2023/50**

(21) Numéro de dépôt: **17702417.1**

(22) Date de dépôt: **02.01.2017**

(51) Classification Internationale des Brevets (IPC):
**H10K 30/00** *(2023.01)*        **H10K 30/84** *(2023.01)*

(52) Classification Coopérative des Brevets (CPC):
**H10K 30/451; H10K 30/84;** H10K 85/1135;
Y02E 10/549; Y02P 70/50

(86) Numéro de dépôt international:
**PCT/FR2017/050001**

(87) Numéro de publication internationale:
**WO 2017/118805 (13.07.2017 Gazette 2017/28)**

(54) **PHOTORÉSISTANCE À SENSIBILITÉ AMÉLIORÉE**

**FOTOWIDERSTAND MIT VERBESSERTER EMPFINDLICHKEIT**

**PHOTORESISTOR WITH IMPROVED SENSITIVITY**

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité:  **05.01.2016  FR 1650048**

(43) Date de publication de la demande:
**14.11.2018  Bulletin 2018/46**

(73) Titulaires:
• **Commissariat à l'Energie Atomique et aux
Energies
Alternatives
75015 Paris (FR)**
• **ISORG
38040 Grenoble Cedex 09 (FR)**

(72) Inventeurs:
• **DAAMI, Anis**
**Bembla 5021 (TN)**
• **BENWADIH, Mohammed**
**94500 Champagny sur Marne (FR)**

(74) Mandataire: **INNOV-GROUP
310, avenue Berthelot
69372 Lyon Cedex 08 (FR)**

(56) Documents cités:
WO-A1-2004/095599        WO-A1-2014/104976
DE-A1-102007 046 444    DE-A1-102011 077 961
FR-A1- 2 977 080            US-A1- 2007 262 303
US-A1- 2013 285 040

Il est rappelé que: Dans un délai de neuf mois à compter de la publication de la mention de la délivrance du brevet européen au Bulletin européen des brevets, toute personne peut faire opposition à ce brevet auprès de l'Office européen des brevets, conformément au règlement d'exécution. L'opposition n'est réputée formée qu'après le paiement de la taxe d'opposition. (Art. 99(1) Convention sur le brevet européen).

EP 3 400 618 B1

**Description**

**Domaine de l'invention**

L'invention concerne le domaine des photorésistances, et en particulier des photorésistances organiques.

**Etat de la technique**

Une photorésistance comporte typiquement deux électrodes associées à une couche photosensible de telle sorte qu'il résulte l'observation d'une résistivité de la photorésistance en fonction d'un flux lumineux impactant la photorésistance. La photorésistance est dite organique lorsque la couche photosensible est formée par un matériau organique, notamment par un semi-conducteur organique.

Une telle photorésistance est caractérisée par un courant de fuite, aussi appelé courant d'obscurité, qui correspond au courant résiduel entre les électrodes soumises à une tension donnée lorsque la photorésistance n'est pas illuminée par le flux lumineux, ou autrement dit lorsque la photorésistance est placée dans l'obscurité.

La sensibilité S d'une telle photorésistance est alors donnée par la formule suivante :

$$S = \frac{Courant_{lumière} - Courant_{obscurité}}{Puissance\,lumineuse\,reçue} \quad \text{éq. 1}$$

où $Courant_{lumière}$ correspond au courant traversant la photorésistance lorsqu'elle est soumise à flux lumineux issu d'une source lumineuse de puissance connue *Puissance lumineuse reçue,* et où $Courant_{obscurité}$ correspond à la valeur de courant d'obscurité décrite précédemment.

Pour améliorer l'utilisation d'une photorésistance, il est préférable que cette dernière présente une sensibilité élevée. Pour cela, il est usuel de jouer sur les caractéristiques de sa couche photosensible et/ou des électrodes en contact avec ladite couche photosensible.

Le document DE102011077961 propose un dispositif photosensible muni d'une couche photosensible et d'une couche additionnelle en contact avec les électrodes et la couche photosensible pour améliorer le fonctionnement du dispositif. Le document US2007262303 divulgue un phototransistor comprenant une couche photosensible et une monocouche auto-assemblée.

Il existe un besoin d'améliorer la sensibilité des photorésistances ou de trouver des alternatives d'amélioration de la sensibilité.

**Objet de l'invention**

Il existe donc un besoin d'optimiser la sensibilité des photorésistances, de préférence en diminuant le courant d'obscurité des photorésistances et/ou en aidant à la conduction des porteurs photo-générés sous lumière.

On tend à satisfaire ce besoin en proposant une photorésistance comprenant deux électrodes reliées par une couche photosensible de la photorésistance, en outre la photorésistance comporte deux couches additionnelles en contact avec la couche photosensible pour avoir une action sur le comportement de la photorésistance vis-à-vis de la collecte des porteurs entre les deux électrodes en vue d'améliorer la sensibilité de la photorésistance.

Selon une réalisation, l'une des couches additionnelles est une monocouche auto-assemblée située entre les deux électrodes et configurée de sorte à augmenter la résistivité de la couche photosensible à son interface avec ladite monocouche auto-assemblée pour réduire le courant d'obscurité de ladite photorésistance.

La couche photosensible peut être de conductivité de type P, et la monocouche auto-assemblée est alors de conductivité de type N.

La couche photosensible peut être de conductivité de type N, et la monocouche auto-assemblée est alors de conductivité de type P.

De préférence, la monocouche auto-assemblée s'étend entre les deux électrodes et n'est pas en contact avec les électrodes.

Avantageusement, l'autre couche additionnelle est une couche de PEDOT:PSS formée sur au moins une partie d'une face avant de la couche photosensible opposée à une face arrière de la couche photosensible en contact avec les électrodes.

Préférentiellement, la photorésistance comporte deux couches additionnelles dont l'une est formée par la monocouche auto-assemblée, et l'autre est formée par la couche de PEDOT:PSS.

Notamment, au moins une partie de la couche photosensible est prise en sandwich entre la couche de PEDOT:PSS et la monocouche auto-assemblée.

Préférentiellement, la couche photosensible est formée par un matériau semi-conducteur organique photosensible.

La couche photosensible est en contact physique avec les électrodes.

L'invention est aussi relative à un procédé de fabrication d'une photorésistance telle que décrite, ce procédé comporte : une étape de formation de deux électrodes de la photorésistance ; une étape de formation d'une couche photosensible de la photorésistance reliant les deux électrodes ; une étape de formation de deux couches additionnelles de la photorésistance destinées à être en contact avec la couche photosensible pour avoir une action sur le comportement de la photorésistance vis-à-vis de la collecte des porteurs entre les deux électrodes en vue d'améliorer la sensibilité de la photorésistance.

Notamment, l'étape de formation des couches additionnelles comporte la formation d'une monocouche auto-assemblée entre les deux électrodes.

Avantageusement, l'étape de formation des couches additionnelles comporte la formation d'une couche de PEDOT:PSS formée sur au moins une partie d'une face avant de la couche photosensible opposée à une face arrière de la couche photosensible en contact avec les électrodes.

**Description des dessins**

L'invention sera mieux comprise à la lecture de la description qui va suivre, donnée uniquement à titre d'exemple non limitatif, et faite en se référant aux dessins sur lesquels :

- la figure 1 est une illustration schématique vue en coupe d'une réalisation d'une photorésistance selon un mode d'exécution de l'invention,
- la figure 2 est un graphique en échelle logarithmique permettant de comparer les courants sous lumière (courbes C3 et C4) et d'obscurité (courbes C1 et C2) d'une photorésistance classique (courbes C1 et C3) avec ceux d'une photorésistance équipée d'une monocouche auto-assemblée sous la couche photosensible et d'une couche PEDOT:PSS par dessus la couche photosensible (courbes C2 et C4) en fonction de la tension appliquée aux bornes des photorésistances,
- la figure 3 permet d'illustrer l'avantage de l'utilisation de la couche de PEDOT:PSS (courbe C6) par rapport à une photorésistance dépourvue d'une telle couche (courbe C5) en donnant l'évolution du courant sous illumination en échelle linéaire en fonction de la tension de bias,
- la figure 4 illustre une étape de formation de deux électrodes notamment sur un substrat,
- la figure 5 illustre la formation d'une monocouche auto-assemblée à partir de la structure de la figure 4,
- la figure 6 (représentant un exemple non compris dans l'invention) illustre la formation d'une couche photosensible sur la structure de la figure 5,
- la figure 7 illustre la formation d'une couche de PEDOT:PSS sur la structure de la figure 6,
- la figure 8 (représentant un exemple non compris dans l'invention) - illustre un autre mode d'exécution comprenant une couche photosensible réalisée sur la structure de la figure 4,
- la figure 9 (représentant un exemple non compris dans l'invention) illustre la formation d'une couche de PEDOT:PSS sur la structure de la figure 8.

Dans ces figures, les mêmes références sont utilisées pour désigner les mêmes éléments.

**Description de modes particuliers de mise en oeuvre de l'invention**

Dans la suite de cette description, les caractéristiques et fonctions bien connues de l'homme du métier ne sont pas décrites en détails.

Dans la présente description, les porteurs font référence, le cas échéant, à des électrons et/ou à des trous.

Dans la présente description, lorsque le mot « transparence » ou le mot « transparent » est utilisé, on fait référence à une transparence au flux lumineux auquel la photorésistance est destinée à être soumise. Notamment, ce flux lumineux est émis par une source de lumière. En particulier, la transparence d'un matériau à un flux de lumière est définie lorsque ce matériau laisse passer au moins 90 % du flux lumineux quand ce dernier frappe son interface, on notera que cela ne veut pas dire que le matériau n'absorbe pas une partie de ce flux lumineux une fois rentré dans son volume.

Pour étalonner une photorésistance, et en connaître ses caractéristiques, il est possible d'appliquer le protocole suivant : placer la photorésistance dans l'obscurité et mesurer le courant d'obscurité pour différentes valeurs de tension fixées ; placer la photorésistance dans une enceinte comportant une source de lumière, par exemple une diode électroluminescente, dont le rendement courant/puissance lumineuse est connu (permettant ainsi de déterminer la puissance de la source lumineuse en mesurant simplement son courant) et mesurer le courant de la photorésistance pour les différentes valeurs de tension fixées, il est alors facile de connaître les caractéristiques de la photorésistance en utilisant l'équation 1 (éq. 1) donnée précédemment. Classiquement, le courant peut être mesuré à l'aide d'un multimètre.

La présente photorésistance diffère de l'art antérieur notamment en ce qu'elle propose l'utilisation d'une couche additionnelle judicieusement placée de telle sorte à présenter une interface de contact avec la couche photosensible de la photorésistance entre les électrodes de la photorésistance.

En reprenant l'équation 1 décrite ci-avant, on propose ici d'améliorer la sensibilité de la photorésistance soit en augmentant le courant apte à la traverser lorsque la photorésistance est soumise à un flux lumineux, soit en diminuant le courant d'obscurité. Ces deux cas permettent d'améliorer indépendamment la sensibilité de la photorésistance. On s'intéresse ici tout particulièrement au comportement des porteurs entre les deux électrodes pour proposer l'ajout d'au moins une couche additionnelle permettant du fait de son contact avec la couche photosensible d'avoir une action sur le comportement de la photorésistance vis-à-vis de la collecte des porteurs entre les électrodes.

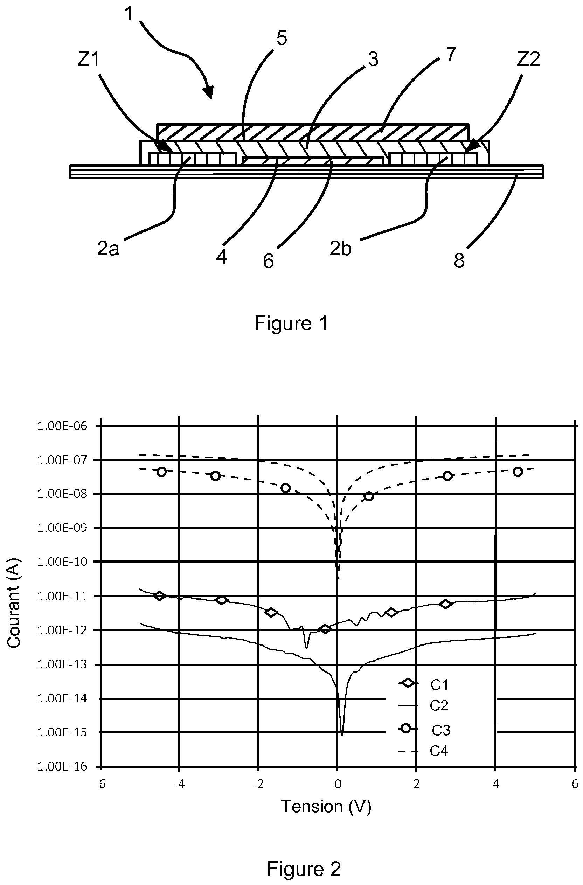

La figure 1 représente une photorésistance 1 selon un mode d'exécution de l'invention. La photorésistance 1 comprend deux électrodes 2a, 2b reliées par une couche photosensible 3 de la photorésistance 1. Autrement dit, la couche photosensible 3 est en contact physique avec les deux électrodes 2a, 2b. Les deux électrodes 2a, 2b peuvent être transparente par exemple formées en ITO (acronyme de l'anglais « Indium Tin Oxyde » pour oxyde indium-étain) d'épaisseur de l'ordre de 50nm, ou bien peuvent être formées dans un autre matériau métallique comme l'or l'argent ou le nickel, ou bien peuvent être formées en TCO (acronyme de l'anglais « Transparent Conducting Oxyde » pour oxyde transparent conducteur) et dans ce cas l'épaisseur des électrodes peut être de 100nm. La couche photosensible 3 est préférentiellement formée par un matériau semi-conducteur organique photosensible, par exemple de type P3HT:PCBM, la photorésistance 1 est alors une photorésistance organique. La couche photosensible 3 présente avantageusement une épaisseur comprise entre 300nm et 800nm, et plus particulièrement entre 500nm et 700nm. En particulier, la couche photosensible 3 comporte une première face 4 dont une première zone Z1 est en contact avec l'une des électrodes 2a et une deuxième zone Z2 est en contact avec l'autre des électrodes 2b. Par ailleurs, la couche photosensible 3 comporte une deuxième face 5 opposée à la première face 4. La distance séparant les première et deuxième faces 4, 5 donne l'épaisseur de la couche photosensible 3. La deuxième face 5 est préférentiellement la face destinée à être orientée vers le flux lumineux. Le P3HT:PCBM est un polymère semi-conducteur de type P (donneur d'électrons) comprenant du P3HT acronyme pour poly(3-hexylthiophène), voire poly(3-hexylthiophène-2,5-diyl) mélangé à un accepteur d'électrons le PCBM acronyme pour [6,6]-phényl-C61-butanoate de méthyle.

En outre, la photorésistance 1 comporte deux couches additionnelles 6, 7 en contact avec la couche photosensible 3 pour avoir une action sur le comportement de la photorésistance vis-à-vis de la collecte des porteurs entre les deux électrodes 2a, 2b en vue d'améliorer la sensibilité de la photorésistance 1. Par « avoir une action sur le comportement de la photorésistance vis-à-vis de la collecte des porteurs entre les deux électrodes », on entend notamment que les couches additionnelles 6, 7 ne sont pas interposées entre l'une ou l'autre des électrodes 2a, 2b et la couche photosensible 3, et qu'une face de la couche additionnelle 6, 7 en contact avec l'une des faces de la couche photosensible 3 comporte au moins une portion qui ne se situe pas en regard de l'une ou l'autre des électrodes 2a, 3b. Autrement dit, ladite portion de la couche additionnelle 6, 7 ne se situe pas à l'aplomb d'une face d'injection/ou de collecte de porteurs de l'une ou l'autre des électrodes 2a, 2b dans la couche photosensible 3.

Dans un premier cas, il est possible d'améliorer la sensibilité de la photorésistance 1 en rendant la couche photosensible 3 moins conductrice électriquement entre les deux électrodes 2a, 2b. Dans ce premier cas, on cherche à réduire le courant d'obscurité. Dans l'obscurité, l'une des électrodes 2a va injecter des porteurs dans la couche photosensible 3, puis ces porteurs vont se propager dans la couche photosensible 3 pour être collectés par l'autre des électrodes 2b. La propagation des porteurs dans l'obscurité est telle qu'il va se former un canal entre les deux électrodes 2a, 2b au niveau de la première face 4 de la couche photosensible 3 en contact avec les deux électrodes 2a, 2b. En augmentant la résistivité du canal, moins d'injection de porteurs sera possible, et par conséquent le courant dû à ces porteurs sera diminué.

Pour mettre en oeuvre le premier cas, la couche additionnelle 6 est préférentiellement une monocouche auto-assemblée 6 située entre les deux électrodes 2a, 2b, et configurée de sorte à augmenter la résistivité de la couche photosensible 3 à son interface avec ladite monocouche auto-assemblée 6 pour réduire le courant d'obscurité de ladite photorésistance 1. La monocouche auto-assemblée 6 est aussi connue dans le domaine sous l'acronyme SAM pour l'anglais « Self-Assembled monolayer ». La monocouche auto-assemblée 6 permet de modifier la résistivité du canal évoquée précédemment. Plus particulièrement, la monocouche auto-assemblée 6 est en contact avec la première face 4 de la couche photosensible 3. Cette monocouche auto-assemblée 6 peut s'étendre entre les deux électrodes 2a, 2b mais n'est pas en contact avec les électrodes 2a, 2b car cela aurait pour conséquence de modifier les travaux de sortie des électrodes 2a, 2b et par conséquent d'induire une mauvaise collection des porteurs photogénérés sous lumière. Autrement dit, la monocouche auto-assemblée est à distance des électrodes 2a, 2b. En fait, la monocouche auto-assemblée joue le rôle d'un défaut entre les électrodes 2a, 2b et permet de capturer les porteurs injectés par les électrodes afin de réduire le courant d'obscurité de la photorésistance. La monocouche auto-assemblée permet de piéger les porteurs qui circulent entre les deux électrodes 2a, 2b sous la couche photosensible 3.

Pour améliorer l'augmentation de la résistivité de la couche photosensible 3 à son interface avec la monocouche auto-assemblée 6, il est possible de tenir compte de la conductivité de la couche photosensible 3. Par conductivité on entend dans la présente description la conductivité électrique. En ce sens, si la couche photosensible 3 est de conductivité de type P, alors la monocouche auto-assemblée est de conductivité de type N, notamment dans ce cas la monocouche auto-assemblée 6 est du 4-methoxythiophenol. Par contre, si la couche photosensible 3 est de type N (c'est à dire de conductivité de type N), alors la monocouche auto-assemblée 6 est de conductivité de type P, notamment dans ce cas la monocouche auto-assemblée 6 est du pentafluoro-benzenethiol. On dit alors que l'on compense la couche photosensible 3 à son interface avec la monocouche auto-assemblée 6, car si la couche photosensible 3 est de type P (porteuse de charge positives : trous), on introduit une monocouche auto-assemblée 6 de type N qui capte les trous, et inversement si la couche photosensible 3 est de type N (porteuse de charge négatives: électrons), on introduit une monocouche auto-assemblée 6 de type P qui capte les électrons. Autrement dit, pour améliorer la photorésistance 1, il est possible d'utiliser des matériaux dopés pour former la couche photosensible 3 et la monocouche auto-assemblée 6. Concernant la couche photosensible 3, le matériau P3HT:PCBM présentant une conduction de type P, il est donc adapté pour la monocouche auto-assemblée 6 de type N. Pour la monocouche auto-assemblée 6 de type P, la couche photosensible 3 alors de conduction de type N peut être du PCNEPV qui est l'acronyme de poly[oxa-1,4-phénylène-(1-cyano-1,2-vinylène)-(2-méthoxy-5-(3,7-diméthyloctyloxy)-1,4-phénylène)-1,2-(2-cyanovinylène)-1,4-phénylène].

On a décrit ci-dessus un exemple de monocouche auto-assemblée avec du 4-methoxythiophenol et un exemple de monocouche auto-assemblée avec du pentafluoro-benzenethiol. De manière plus générale, une monocouche auto-assemblée peut comporter du, ou être en, Benzenethiol (dont le sigle est BT), ou du 4-nitrobenzenethiol (dont le sigle est NBT), ou du 4-methylbenzenethiol (dont le sigle est MBT), ou du 4-hydroxybenzenethiol (HBT), ou du 4-methoxybenzenethiol (dont le sigle est MOBT), ou du 4-fluorobenzenethiol (dont le sigle est FBT), ou du Pentafluorobenzenethiol (dont le sigle est PFBT), ou du 4-chlorobenzenethiol (dont le sigle est CBT), ou du Pentachlorobenzenethiol (dont le sigle est PCBT), ou du 4-bromobenzenethiol (dont le sigle est BBT).

Dans le cas où la monocouche auto-assemblée comporte du, ou est en, Benzenethiol (BT), ou du 4-nitrobenzenethiol (NBT), ou du 4-methylbenzenethiol (MBT), ou du 4-hydroxybenzenethiol (HBT), ou du 4-methoxybenzenethiol (MOBT), il s'agit d'une monocouche auto-assemblée de conductivité de type N. Dans le cas où la monocouche auto-assemblée comporte du, ou est en, du 4-fluorobenzenethiol (FBT), ou du Pentafluorobenzenethiol (PFBT), ou du 4-chlorobenzenethiol (CBT), ou du Pentachlorobenzenethiol (PCBT), ou du 4-bromobenzenethiol (BBT), il s'agit d'une monocouche auto-assemblée de conductivité de type P.

Les exemples donnés ci-dessus pour réaliser les monocouches auto-assemblées permettent de réduire le courant d'obscurité de la photorésistance en piégeant des porteurs de charge le cas échéant les électrons ou les trous injectés lorsque la photorésistance est polarisée mais qu'elle n'est pas illuminée, ceci ayant pour effet d'avoir une action sur le comportement de la photorésistance vis à vis de la collecte des porteurs puisque le courant en sera réduit.

Le premier cas est notamment mis en oeuvre lorsque la photorésistance 1 est intégrée à un détecteur, à un imageur matriciel ou encore utilisée seule, en effet dans ce cas le courant noir définit le seuil minimum de détection d'un tel détecteur ou imageur.

Dans un deuxième cas, il est possible d'améliorer la sensibilité en augmentant au moins localement la conductivité de la couche photosensible 3. En fait, lorsque la photorésistance 1 est placée sous un flux lumineux cela génère des porteurs au sein de la couche photosensible 3 qu'il faut récupérer/collecter au niveau des électrodes le plus rapidement possible pour éviter leurs recombinaisons. Il est donc proposé ici de fournir à ces porteurs un chemin énergétiquement plus favorable à suivre pour améliorer la collecte desdits porteurs par les électrodes 2a, 2b. Dans ce cas, la couche additionnelle 7 permet de réaliser cette fonction.

Pour mettre en oeuvre ce deuxième cas, la couche additionnelle 7 peut être une couche de PEDOT:PSS 7 notamment formée sur au moins une partie d'une face avant - la deuxième face 5 évoquée précédemment - de la couche photosensible 3 opposée à une face arrière - la première face 4 évoquée précédemment - de la couche photosensible 3 en contact avec les électrodes 2a, 2b, et notamment destinée à être orientée vers le flux lumineux. Autrement dit, cette couche de PEDOT:PSS 7 est transparente. Le PEDOT:PSS présente l'avantage d'avoir une conductivité électrique plus haute que la couche photosensible 3, notamment lorsque cette dernière est en P3HT:PCBM. Notamment, le PEDOT:PSS peut être généralisé à une couche en matériau polymère ayant une conductivité plus élevée que la couche photosensible 3. Cette couche de PEDOT:PSS peut avoir une épaisseur de l'ordre du micromètre, et plus particulièrement comprise entre 200nm et 500nm. Notamment, ici le PEDOT:PSS est dit « flottant », c'est-à-dire qu'il n'est pas utilisé comme une électrode, et il permet une amélioration de la sensibilité de la photorésistance lorsque la photorésistance est sous lumière en aidant à la conduction des porteurs photo-générés sous lumière.

On comprend que dans le deuxième cas la couche additionnelle 7 est à distance des électrodes. Autrement dit, les premier et deuxième cas peut être généralisés de la manière suivante : ladite au moins une couche additionnelle 7 est à distance des électrodes : c'est-à-dire qu'elle n'est pas en contact avec les électrodes.

Le PEDOT :PSS ( poly(3,4-ethylenedioxythiophene) polystyrène sulfonate) est un polymère qui est un mélange de deux composants ionomères, le PEDOT : poly(3,4-ethylenedioxythiophene) qui un polymère conjugué et le PSS : sodium polystyrène sulfonate qui est un polystyrène sulfoné. Le mélange forme un polymère transparent conducteur avec une très bonne conductivité. Il peut transporter des électrons comme des trous. En ce sens, dans le cadre de la présente invention le PEDOT:PSS permet, d'une part, le passage du flux lumineux pour que celui-ci puisse générer des porteurs dans la couche photosensible 3, et d'autre part, de favoriser le transport des porteurs générés dans la couche photosensible 3 pour améliorer leur collecte et donc limiter leur recombinaison.

Les premier et deuxième cas évoqués ci-dessus permettent chacun d'améliorer la sensibilité. La photorésistance 1 comporte deux couches additionnelles 6, 7 dont l'une est formée par la monocouche auto-assemblée 6, et l'autre est formée par la couche de PEDOT:PSS 7.

La figure 2 est un graphique donnant le courant traversant la photorésistance 1 en fonction de la tension appliquée aux électrodes 2a, 2b selon quatre courbes C1, C2, C3, C4. Ces quatre courbes ont été obtenues selon le protocole décrit précédemment. La courbe C1 représente le courant en fonction de la tension lorsque la photorésistance 1, dépourvue de la monocouche auto-assemblée 6 et de la couche de PEDOT:PSS, est placée dans l'obscurité. La courbe C2 représente le courant en fonction de la tension lorsque la photorésistance 1 comporte la monocouche auto-assemblée 6 et la couche de PEDOT:PSS, et est placée dans l'obscurité. La courbe C3 représente le courant en fonction de la tension lorsque la photorésistance 1, dépourvue de la monocouche auto-assemblée 6 et de la couche de PEDOT:PSS, est placée sous un flux lumineux calibré. La courbe C4 représente le courant en fonction de la tension lorsque la photorésistance 1 comporte la monocouche auto-assemblée 6 et la couche de PEDOT:PSS, et est placée sous un flux lumineux calibré. Il est ainsi possible d'observer une réduction de l'ordre d'une décade sur le courant d'obscurité en fonction de la mise en oeuvre ou non de la monocouche auto-assemblée 6 et de la couche de PEDOT:PSS (courbes C1 et C2). On constate que le courant de fuite/courant d'obscurité est plus élevé sans la monocouche auto-assemblée 6 qu'avec. En fait, la monocouche auto-assemblée 6 agit à son interface avec la couche photosensible 3 comme des sites de piégeage de porteurs. Ainsi, quand les porteurs sont injectés d'une électrode vers une autre, ils sont piégés sur les sites (tentacules de polymère qui captent/piègent les porteurs), et par conséquent le flux de porteurs diminue par comparaison au courant de fuite s'il n'y a pas de monocouche auto-assemblée 6. Par ailleurs, les courbes C3 et C4 permettent aussi de visualiser le gain notamment associé à la couche de PEDOT:PSS. En résumé, le gain du courant d'obscurité s'explique par la présence de la monocouche auto-assemblée 6 et le gain en courant de lumière est dû au PEDOT:PSS 7, chacun ayant un rôle différent.

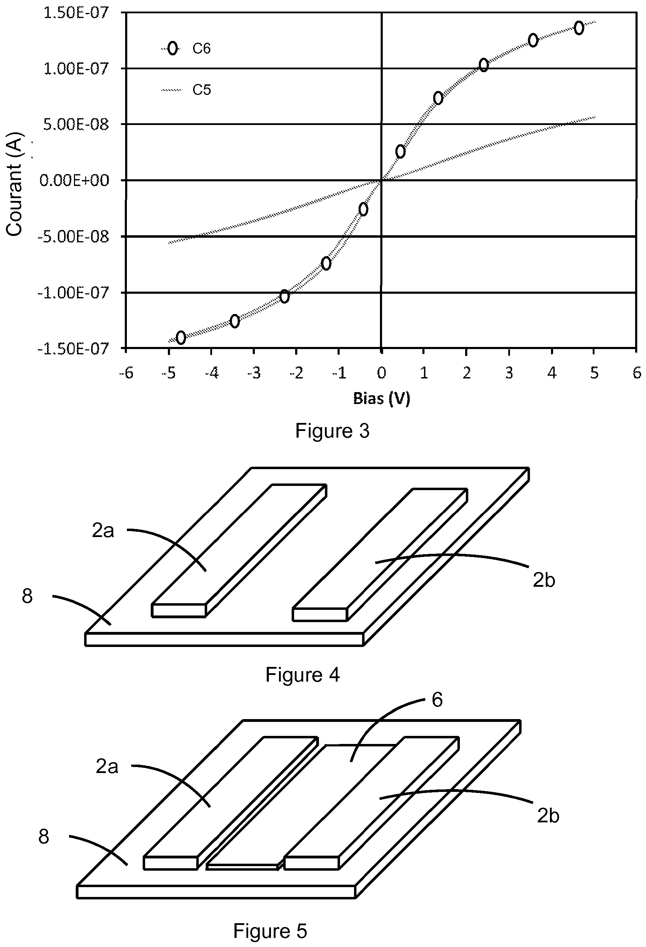

La figure 3 illustre le courant traversant la photorésistance en fonction de sa tension de bias en échelle linéaire. La courbe C5 représente l'évolution du courant traversant la photorésistance 1 sans la couche de PEDOT :PSS 7 (et sans la monocouche auto-assemblée) sous lumière en fonction de la tension de bias, et la courbe C6 représente l'évolution du courant traversant la photorésistance 1 avec la couche de PEDOT :PSS 7 (et avec la monocouche auto-assemblée 6) sous lumière en fonction de la tension de bias. En fait cette figure 3 est une reprise sous échelle linéaire des courbes sous illuminations (courbes C3 à C5 et C4 à C6) de la figure 2 permettant de montrer l'augmentation du gain sous lumière. La courbe C6 apparaît dédoublée car il est réalisé un aller retour sur le bias pendant l'expérience. Pour une tension de bias de 5V, on note une multiplication du courant traversant la photorésistance 1 par trois grâce à l'utilisation de la couche de PEDOT:PSS 7.

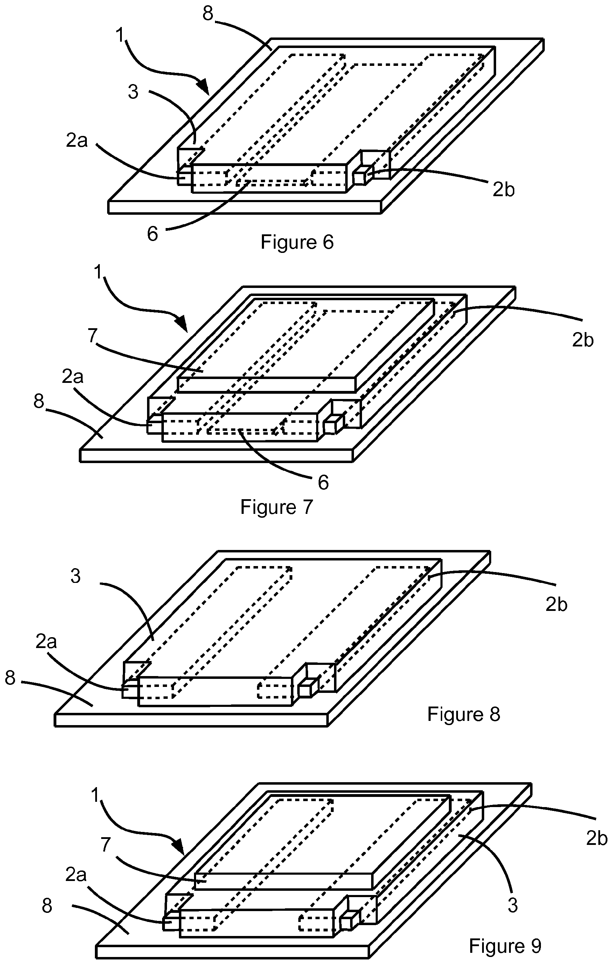

La combinaison des premier et deuxième cas est illustrée en figures 1 et 7. La figure 6 illustre le premier cas pris seul, et la figure 9 illustre le deuxième cas pris seul. Dans le cadre de la combinaison des premier et deuxième cas, chaque couche (la monocouche auto-assemblée et la couche de PEDOT:PSS ) intervient pour un courant donné, la somme se traduit à travers l'équation 1 qui montre que le gain du PEDOT:PSS 7 a plus d'effet sur la sensibilité globale que la monocouche auto-assemblée 6 car le courant sous lumière est très élevé par rapport au courant d'obscurité (la monocouche auto-assemblée améliorant seulement le seuil de sensibilité de la photorésistance).

Comme visible en figure 1, au moins une partie de la couche photosensible 3 est prise en sandwich entre la couche de PEDOT:PSS 7 et la monocouche auto-assemblée 6, on profite alors des deux faces pour améliorer deux caractéristiques de la sensibilité de la photorésistance à savoir augmenter le courant sous lumière et diminuer le courant d'obscurité.

Plus particulièrement, la photorésistance 1 comporte un substrat 8 sur lequel sont disposées les électrodes 2a, 2b ainsi que la monocouche auto-assemblée 7 alors formée sur le substrat 8 dans un espace situé entre les électrodes 2a, 2b.

L'invention est aussi relative à un procédé de fabrication de la photorésistance 1 telle que décrite. Les figures 4 à 9 illustrent différentes étapes d'un tel procédé. Les éléments représentés en pointillés sur les figures 6 à 9 sont des éléments recouverts et non visibles depuis l'extérieur. Notamment, le procédé de fabrication comporte les étapes suivantes : une étape de formation de deux électrodes 2a, 2b de la photorésistance (figure 4) ; une étape de formation d'une couche photosensible 3 de la photorésistance reliant les deux électrodes 2a, 2b (figures 6 et 8) ; une étape de formation de deux couches additionnelles 6, 7 (figure 7) de la photorésistance 1 destinée à être en contact avec la couche photosensible 3 pour avoir une action sur le comportement de la photorésistance vis-à-vis de la collecte des porteurs entre les deux électrodes 2a, 2b en vue d'améliorer la sensibilité de la photorésistance 1.

L'étape de formation des deux électrodes 2a, 2b, préférentiellement transparentes, peut être réalisée par dépôt sur un substrat 8 adapté (figure 4). En particulier, les deux électrodes 2a, 2b peuvent être déposées par l'une des techniques suivantes : la sérigraphie, l'impression, l'évaporation par CVD acronyme de l'anglais « Chemical Vapor Déposition » pour dépôt chimique en phase vapeur, l'évaporation par PVD acronyme de l'anglais « Physical Vapor Déposition » pour dépôt physique en phase vapeur. D'autres techniques de dépôt des électrodes 2a, 2b peuvent aussi être envisagées par l'homme du métier. Ces électrodes peuvent présenter une épaisseur comprise entre 20nm et 100nm et préférentiellement égale à 50nm si il s'agit d'électrodes en métal (or, nickel, argent), ou comprise entre 70nm et 150nm et préférentiellement égale à 100nm si il s'agit de TCO.

Le substrat 8 peut être flexible ou rigide, et transparent à la lumière. Par exemple, le substrat 8 peut être de type choisi parmi PEN (acronyme de Polyéthylène Naphthalate), PET (acronyme de Polyéthylène Terephtalate), Kapton® (film Polyimide développé par la société Dupont et correspondant à du poly (4,4'-oxydiphenylene-pyromellitimide)), ou autre. Le substrat 8 est préférentiellement en verre ou plastique de telle sorte à permettre l'illumination de la couche photosensible 3 des deux côtés.

Selon une mise en oeuvre particulière, les électrodes 2a, 2b peuvent être réalisées de la manière suivante : le substrat 8 de verre ou de plastique est recouvert de 125 nm d'ITO déposé par pulvérisation puis nettoyé par bain à ultrasons successivement dans l'EDI (acronyme de eau dé ionisée), l'acétone et l'isopropanol durant 10 minutes pour chacun des bains. Le substrat 8 est ensuite séché sous flux d'azote. L'étape de formation des électrodes 2a, 2b comporte alors ensuite une étape de photo-lithographie réalisée pour définir le motif des électrodes 2a, 2b. Durant cette étape de photo-lithographie, de la résine photosensible est déposée à la tournette sur la couche d'ITO. Un masque comportant les motifs des électrodes 2a, 2b est ensuite déposé sur la résine qui est enfin insolée sous une lampe à ultraviolets. La résine non insolée est retirée dans un bain chimique, et la couche d'ITO mise à nue est gravée pendant 5 minutes dans un bain d'acide chlorhydrique. La résine insolée est ensuite retirée dans un bain chimique spécifique. Puis le substrat 8 est à nouveau nettoyé avec les mêmes bains à ultrasons pour obtenir in fine les deux électrodes 2a, 2b formées sur le substrat 8.

Préférentiellement, pour le premier cas, l'étape de formation de la couche additionnelle 6 (figure 5) comporte la formation, notamment avant l'étape de formation de la couche photosensible 3 (figure 6), de la monocouche auto-assemblée 6 entre les deux électrodes 2a, 2b, notamment de telle sorte que cette monocouche auto-assemblée 6 ne soit pas en contact avec les deux électrodes 2a, 2b. En particulier, cette monocouche auto-assemblée 6 est déposée sur le substrat 8 entre les deux électrodes 2a, 2b formées sur ce substrat 8. Le dépôt de cette monocouche auto-assemblée 6 peut se faire par trempage dans une solution préalablement préparée ou par impression. Plus généralement, on dit que l'étape de formation de la mono-couche auto-assemblée 6 est une étape de greffage. De préférence, la monocouche auto-assemblée 6 présente une épaisseur de l'ordre de la longueur des molécules utilisées. En particulier, l'épaisseur de la monocouche auto-assemblée 6 est comprise entre 0,5nm et 1nm.

Toujours dans le premier cas, l'étape de formation de la couche photosensible 3 est ensuite réalisée (figure 6) par dépôt de cette dernière sur les électrodes 2a, 2b et sur la monocouche auto-assemblée 6, notamment de telle sorte que cette dernière recouvre les parties libres des électrodes 2a, 2b et de la monocouche auto-assemblée 6 au préalable de son dépôt et vienne en contact avec le substrat 8. L'étape de formation de la couche photosensible 3 est notamment telle qu'après son dépôt ladite couche photosensible 3 présente une épaisseur comprise entre 300nm et 800nm.

Selon un exemple de réalisation qui ne fait pas partie de l'invention, la couche photosensible 3 est déposée sur les électrodes 2a, 2b, et notamment sur le substrat 8 entre les deux électrodes 2a, 2b (figure 8). Cette couche photosensible 3 peut présenter les mêmes caractéristiques de matériau ou d'épaisseur que dans le premier cas. Ensuite, après formation de la couche photosensible 3, l'étape de formation de la couche additionnelle 7 consiste alors à déposer sur la couche photosensible 3 une couche de PEDOT:PSS 7 (figure 9). Dans cet exemple non compris dans l'invention, la monocouche auto-assemblée n'est pas présente dans la photorésistance 1.

Selon l'invention, la photorésistance comprend deux couches additionnelles 6, 7. Dès lors, après formation de la couche photosensible 3, l'étape de formation de la couche additionnelle 6 comporte en outre une étape de formation de la couche de PEDOT:PSS 7 formée sur au moins une partie d'une face avant de la couche photosensible 3 (figure 7) . On comprend alors que l'étape de formation de deux couches additionnelles 6, 7 dont l'une - la monocouche auto-assemblée 6 - est réalisée avant l'étape de formation de la couche photosensible 3, et dont l'autre - la couche de PEDOT:PSS 7 - est formée après l'étape de formation de la couche photosensible 3.

Autrement dit, l'étape de formation des deux couches additionnelles comporte la formation d'une couche de PEDOT:PSS 7 notamment formée sur au moins une partie de la face avant 5 de la couche photosensible 3 opposée à une face arrière de la couche photosensible 3 en contact avec les électrodes 2a, 2b. La couche de PEDOT:PSS peut recouvrir la couche photosensible 3 jusqu'au substrat bien entendu si elle ne crée pas de court-circuit entre les électrodes.

De manière générale, la formation de la couche de PEDOT:PSS 7 peut être réalisée par dépôt, notamment de type choisi parmi : un dépôt par enduction centrifuge, un dépôt par impression ou un dépôt par sérigraphie. En particulier, la couche de PEDOT:PSS peut être déposée par sérigraphie à travers un masque, et une fois la couche déposée 7, le substrat 8 est recuit sous flux d'azote à 110°C durant 20 minutes pour faire évaporer l'eau.

Le PEDOT:PSS utilisé peut être celui de la société Heraeus:Clevios connu sous la référence PVPAI4083®.

La couche photosensible 3 peut être formée par la préparation d'une solution de P3HT:PCBM à une concentration totale de 50 mg/ml et un ratio polymère (P3HT):fullerène(PCBM) de 1:1 dans une solution de chlorobenzène. La solution est mise sous agitation durant 3 heures sur une plaque chauffante à 60°C. Le matériau est ensuite déposé par sérigraphie à travers un masque préalablement dessiné pour avoir la bonne dimension de la photorésistance. Un recuit de 5 min à 80°C est ensuite réalisé pour faire évaporer le solvant. Bien entendu, le dépôt de cette solution peut aussi être réalisé par d'autres techniques comme la sérigraphie, l'enduction centrifuge ou l'impression.

De manière générale, la photorésistance et le procédé sont liés de telle manière que toutes les caractéristiques de la photorésistance peuvent être réalisées au cours d'étapes adaptées du procédé, et que toutes les caractéristiques structurelles décrites en combinaison avec le procédé, notamment les épaisseurs des couches et les matériaux utilisés, peuvent être intégrées à la photorésistance.

En particulier, bien que la face 5 de la couche photosensible 3 soit celle préférée à orienter vers la source du flux lumineux à quantifier, les gammes d'épaisseur données précédemment pour les électrodes 2a, 2b, la monocouche auto-assemblée 6, la couche de PEDOT:PSS 7 sont notamment telles que ces éléments sont transparents pour permettre un éclairage de la photorésistance 1 aussi bien par sa face avant située au niveau de la couche de PEDOT:PSS 1 que de sa face arrière située au niveau de la monocouche auto-assemblée 6 ou du substrat 8 (alors lui aussi transparent).

La photorésistance telle que décrite peut être utilisée pour former un capteur de lumière, une matrice de détection à base de photorésistances ou autre imageur.

Sur les figures 6 à 9, il est possible de noter que la couche photosensible 3 ne recouvre pas entièrement les électrodes, ceci a pour but de laisser au niveau de chaque électrode 2a, 2b une zone de prise de contact.

Selon une mise en oeuvre, au cours de la fabrication, il peut y avoir une pluralité de monocouches auto-assemblées. Toutefois une seule se greffe, les autres monocouches auto-assemblées étant juste posées/adsorbées (il n'y a pas d'attaque chimique). En cas de rinçage lors du procédé de fabrication, il ne reste que la couche greffée.

**Revendications**

1. Photorésistance (1) comprenant deux électrodes (2a, 2b) reliées par une couche photosensible (3) de la photorésistance (1), la couche photosensible (3) étant en contact physique avec les électrodes (2a, 2b), la couche photosensible (3) comportant une première face (4) et une deuxième face (5) opposée à la première face (4) et destinée à être orientée vers le flux lumineux, **caractérisée en ce que** la photorésistance (1) comporte deux couches additionnelles (6, 7) en contact avec la couche photosensible (3) pour avoir une action sur le comportement de la photorésistance vis-à-vis de la collecte des porteurs entre les deux électrodes (2a, 2b) en vue d'améliorer la sensibilité de la photorésistance (1), l'une de ces couches additionnelles étant formée sur l'une des faces (4, 5) de la couche photosensible (3) et étant configurée de sorte à augmenter la résistivité de la couche photosensible (3) à son interface avec ladite couche additionnelle, et l'autre de ces couches additionnelles étant formée sur l'autre face (4, 5) de la couche photosensible et étant configurée de sorte à augmenter au moins localement la conductivité de la couche photosensible (3).

2. Photorésistance selon la revendication précédente, **caractérisée en ce que** la couche additionnelle configurée de sorte à augmenter la résistivité de la couche photosensible (3) est une monocouche auto-assemblée (6) située entre les deux électrodes (2a, 2b) pour réduire le courant d'obscurité de ladite photorésistance.

3. Photorésistance selon la revendication précédente, **caractérisée en ce que** la couche photosensible (3) est de conductivité de type P, et **en ce que** la monocouche auto-assemblée (6) est de conductivité de type N.

4. Photorésistance selon la revendication 2, **caractérisée en ce que** la couche photosensible (3) est de conductivité de type N, et **en ce que** la monocouche auto-assemblée (6) est de conductivité de type P.

5. Photorésistance selon l'une quelconque des revendications 2 à 4, **caractérisée en ce que** la mono-couche auto-assemblée (6) s'étend entre les deux électrodes (2a, 2b) et n'est pas en contact avec les électrodes (2a, 2b).

6. Photorésistance selon la revendication 1, **caractérisée en ce que** la couche additionnelle configurée de sorte à augmenter au moins localement la conductivité de la couche photosensible (3) est une couche de PEDOT:PSS (7) formée sur au moins une partie d'une face avant (5) de la couche photosensible (3) opposée à une face arrière (4) de la couche photosensible (3) en contact avec les électrodes (2a, 2b).

7. Photorésistance selon la revendication 6, **caractérisé en ce que** au moins une partie de la couche photosensible (3) est prise en sandwich entre la couche de PEDOT:PSS (7) et la couche additionnelle configurée de sorte à augmenter la résistivité de la couche photosensible (3), cette couche additionnelle étant une monocouche auto-assemblée (6).

8. Photorésistance selon l'une quelconque des revendications précédentes, **caractérisée en ce que** la couche photosensible (3) est formée par un matériau semi-conducteur organique photosensible.

9. Procédé de fabrication d'une photorésistance (1) selon l'une quelconque des revendications précédentes, **caractérisé en ce qu'**il comporte :

• Une étape de formation de deux électrodes

(2a, 2b) de la photorésistance (1),

• Une étape de formation d'une couche photosensible (3) de la photorésistance (1) reliant les deux électrodes (2a, 2b) et en contact physique avec les deux électrodes, la couche photosensible (3) comportant une première face (4) et une deuxième face (5) opposée à la première face (4) et destinée à être orientée vers le flux lumineux,

• Une étape de formation de deux couches additionnelles (6, 7) de la photorésistance (1) destinées à être en contact avec la couche photosensible (3) pour avoir une action sur le comportement de la photorésistance vis-à-vis de la collecte des porteurs entre les deux électrodes (2a, 2b) en vue d'améliorer la sensibilité de la photorésistance (1), l'une de ces couches additionnelles étant formée sur l'une des faces (4, 5) de la couche photosensible (3) et étant configurée de sorte à augmenter la résistivité de la couche photosensible (3) à son interface avec ladite couche additionnelle, et l'autre de ces couches additionnelles étant formée sur l'autre face (4, 5) de la couche photosensible et étant configurée de sorte à augmenter au moins localement la conductivité de la couche photosensible (3).

10. Procédé selon la revendication 9, **caractérisé en ce que** l'étape de formation de la couche additionnelle configurée de sorte à augmenter la résistivité de la couche photosensible (3) comporte la formation d'une monocouche auto-assemblée (6) entre les deux électrodes (2a, 2b).

11. Procédé selon l'une quelconque des revendications 9 à 10, **caractérisé en ce que** l'étape de formation de la couche additionnelle configurée de sorte à augmenter au moins localement la conductivité de la couche photosensible (3) comporte la formation d'une couche de PEDOT:PSS (7) formée sur au moins une partie de la face avant (5) de la couche photosensible (3) opposée à une face arrière de la couche photosensible (3) en contact avec les électrodes (2a, 2b).

## Patentansprüche

1. Fotowiderstand (1), umfassend zwei Elektroden (2a, 2b), die durch eine fotosensitive Schicht (3) des Fotowiderstands (1) verbunden sind, wobei die fotosensitive Schicht (3) in physischem Kontakt mit den Elektroden (2a, 2b) ist, wobei die fotosensitive Schicht (3) eine erste Seite (4) aufweist und eine zweite Seite (5), die zu der ersten Seite (4) entgegengesetzt ist und dazu bestimmt ist, zu dem Lichtfluss hin ausgerichtet zu sein, **dadurch gekennzeichnet, dass** der Fotowiderstand (1) zwei zusätzliche Schichten (6, 7) aufweist, die in Kontakt mit der fotosensitiven Schicht (3) sind, um eine Wirkung auf das Verhalten des Fotowiderstands gegenüber dem Sammeln der Ladungsträger zwischen den beiden Elektroden (2a, 2b) zwecks Verbesserung der Empfindlichkeit des Fotowiderstands (1) zu erhalten, wobei die eine dieser zusätzlichen Schichten auf der einen der Seiten (4, 5) der fotosensitiven Schicht (3) gebildet ist und so ausgestaltet ist, dass sie den spezifischen Widerstand der fotosensitiven Schicht (3) an ihrer Grenzfläche zu der zusätzlichen Schicht erhöht, und wobei die andere dieser zusätzlichen Schichten auf der anderen Seite (4, 5) der fotosensitiven Schicht gebildet ist und so ausgestaltet ist, dass sie die Leitfähigkeit der fotosensitiven Schicht (3) mindestens lokal erhöht.

2. Fotowiderstand nach dem vorhergehenden Anspruch, **dadurch gekennzeichnet, dass** die zusätzliche Schicht, die so ausgestaltet ist, dass sie den spezifischen Widerstand der fotosensitiven Schicht (3) erhöht, eine selbstorganisierende Monoschicht (6) ist, die zwischen den beiden Elektroden (2a, 2b) angeordnet ist, um den Dunkelstrom des Fotowiderstands zu reduzieren.

3. Fotowiderstand nach dem vorhergehenden Anspruch, **dadurch gekennzeichnet, dass** die fotosensitive Schicht (3) eine p-Leitfähigkeit hat und dass die selbstorganisierende Monoschicht (6) eine n-Leitfähigkeit hat.

4. Fotowiderstand nach Anspruch 2, **dadurch gekennzeichnet, dass** die fotosensitive Schicht (3) eine n-Leitfähigkeit hat und dass die selbstorganisierende Monoschicht (6) eine p-Leitfähigkeit hat.

5. Fotowiderstand nach einem der Ansprüche 2 bis 4, **dadurch gekennzeichnet, dass** die selbstorganisierende Monoschicht (6) sich zwischen den beiden Elektroden (2a, 2b) erstreckt und nicht mit den Elektroden (2a, 2b) in Kontakt ist.

6. Fotowiderstand nach Anspruch 1, **dadurch gekennzeichnet, dass** die zusätzliche Schicht, die so ausgestaltet ist, dass sie die Leitfähigkeit der fotosensitiven Schicht (3) mindestens lokal erhöht, eine PEDOT:PSS-Schicht (7) ist, die auf mindestens einem Teil einer Vorderseite (5) der fotosensitiven Schicht (3) gebildet ist, die entgegengesetzt zu einer Rückseite (4) der fotosensitiven Schicht (3) ist, die in Kontakt mit den Elektroden (2a, 2b) ist.

7. Fotowiderstand nach Anspruch 6, **dadurch gekennzeichnet, dass** mindestens ein Teil der fotosensitiven Schicht (3) zwischen der PEDOT:PSS-Schicht (7) und der zusätzlichen Schicht, die so ausgestaltet ist, dass sie den spezifischen Widerstand der fotosensitiven Schicht (3) erhöht, sandwichartig aufgenommen ist, wobei diese zusätzliche Schicht (6) eine selbstorganisierende Monoschicht ist.

8. Fotowiderstand nach einem der vorhergehenden Ansprüche, **dadurch gekennzeichnet, dass** die fotosensitive Schicht (3) durch ein fotosensitives organisches Halbleitermaterial gebildet wird.

9. Verfahren zur Herstellung eines Fotowiderstands (1) nach einem der vorhergehenden Ansprüche, **dadurch gekennzeichnet, dass** es umfasst:

    • einen Schritt des Bildens von zwei Elektroden (2a, 2b) des Fotowiderstands (1),
    • einen Schritt des Bildens einer fotosensitiven Schicht (3) des Fotowiderstands (1), die die beiden Elektroden (2a, 2b) verbindet und in physischem Kontakt mit den beiden Elektroden ist, wobei die fotosensitive Schicht (3) eine erste Seite (4) aufweist und eine zweite Seite (5), die zu der ersten Seite (4) entgegengesetzt ist und dazu bestimmt ist, zu dem Lichtfluss hin ausgerichtet zu sein,
    • einen Schritt des Bildens von zwei zusätzlichen Schichten (6, 7) des Fotowiderstands (1), die dazu bestimmt sind, in Kontakt mit der fotosensitiven Schicht (3) zu sein, um eine Wirkung auf das Verhalten des Fotowiderstands gegenüber dem Sammeln der Ladungsträger zwischen den beiden Elektroden (2a, 2b) zwecks Verbesserung der Empfindlichkeit des Fotowiderstands (1) zu erhalten, wobei die eine dieser zusätzlichen Schichten auf der einen der Seiten (4, 5) der fotosensitiven Schicht (3) gebildet ist und so ausgestaltet ist, dass sie den spezifischen Widerstand der fotosensitiven Schicht (3) an ihrer Grenzfläche zu der zusätzlichen Schicht erhöht, und wobei die andere dieser zusätzlichen Schichten auf der anderen Seite (4, 5) der fotosensitiven Schicht gebildet ist und so ausgestaltet ist, dass sie die Leitfähigkeit der fotosensitiven Schicht (3) mindestens lokal erhöht.

10. Fotowiderstand nach Anspruch 9, **dadurch gekennzeichnet, dass** der Schritt des Bildens der zusätzlichen Schicht, die so ausgestaltet ist, dass sie den spezifischen Widerstand der fotosensitiven Schicht (3) erhöht, das Bilden einer selbstorganisierenden Monoschicht (6) zwischen den beiden Elektroden (2a, 2b) umfasst.

11. Verfahren nach einem der Ansprüche 9 bis 10, **dadurch gekennzeichnet, dass** der Schritt des Bildens der zusätzlichen Schicht, die so ausgestaltet ist, dass sie die Leitfähigkeit der fotosensitiven Schicht (3) mindestens lokal erhöht, das Bilden einer PEDOT:PSS-Schicht (7) umfasst, die auf mindestens einem Teil einer Vorderseite (5) der fotosensitiven Schicht (3) gebildet ist, die entgegengesetzt zu einer Rückseite der fotosensitiven Schicht (3) ist, die in Kontakt mit den Elektroden (2a, 2b) ist.

**Claims**

1. Photoresistor (1) comprising two electrodes (2a, 2b) connected by a photosensitive layer (3) of the photoresistor (1), the photosensitive layer (3) being in physical contact with the electrodes (2a, 2b), the photosensitive layer (3) comprising a first face (4) and a second face (5) opposite the first face (4) and intended to be oriented towards the luminous flux, **characterized in that** the photoresistor (1) comprises two additional layers (6, 7) in contact with the photosensitive layer (3) so as to have an action on the behaviour of the photoresistor with respect to collection of the carriers between the two electrodes (2a, 2b) in order to improve the sensitivity of the photoresistor (1), one of these additional layers being formed on one of the faces (4, 5) of the photosensitive layer (3) and being configured so as to increase the resistivity of the photosensitive layer (3) at its interface with said additional layer, and the other of these additional layers being formed on the other face (4, 5) of the photosensitive layer and being configured so as to increase at least locally the conductivity of the photosensitive layer (3).

2. Photoresistor according to the preceding claim, **characterized in that** the additional layer configured so as to increase the resistivity of the photosensitive layer (3) is a self-assembled monolayer (6) located between the two electrodes (2a, 2b) to reduce the dark current of said photoresistor.

3. Photoresistor according to the preceding claim, **characterized in that** the photosensitive layer (3) is of p-type conductivity, and **in that** the self-assembled monolayer (6) is of n-type conductivity.

4. Photoresistor according to Claim 2, **characterized in that** the photosensitive layer (3) is of n-type conductivity, and **in that** the self-assembled monolayer (6) is of p-type conductivity.

5. Photoresistor according to any one of Claims 2 to 4, **characterized in that** the self-assembled monolayer (6) extends between the two electrodes (2a, 2b) and is not in contact with the electrodes (2a, 2b).

6. Photoresistor according to Claim 1, **characterized in that** the additional layer configured so as to increase at least locally the conductivity of the photosensitive layer (3) is a PEDOT:PSS layer (7) formed on at least a part of a front face (5) of the photosensitive layer (3) opposite a rear face (4) of the photosensitive layer (3) in contact with the electrodes (2a, 2b).

7. Photoresistor according to Claim 6, **characterized in that** at least a part of the photosensitive layer (3) is sandwiched between the PEDOT:PSS layer (7) and the additional layer configured so as to increase the resistivity of the photosensitive layer (3), this additional layer being a self-assembled monolayer (6).

8. Photoresistor according to any one of the preceding claims, **characterized in that** the photosensitive layer (3) is formed from a photosensitive organic semiconductor material.

9. Method of fabrication of a photoresistor (1) according to any one of the preceding claims, **characterized in that** it comprises:

   • A step of forming two electrodes (2a, 2b) of the photoresistor (1),
   • A step of forming a photosensitive layer (3) of the photoresistor (1) connecting the two electrodes (2a, 2b) and being in physical contact with the two electrodes, the photosensitive layer (3) comprising a first face (4) and a second face (5) opposite the first face (4) and intended to be oriented towards the luminous flux,
   • A step of forming two additional layers (6, 7) of the photoresistor (1) intended to be in contact with the photosensitive layer (3) so as to have an action on the behaviour of the photoresistor with respect to collection of the carriers between the two electrodes (2a, 2b) in order to improve the sensitivity of the photoresistor (1), one of these additional layers being formed on one of the faces (4, 5) of the photosensitive layer (3) and being configured so as to increase the resistivity of the photosensitive layer (3) at its interface with said additional layer, and the other of these additional layers being formed on the other face (4, 5) of the photosensitive layer and being configured so as to increase at least locally the conductivity of the photosensitive layer (3).

10. Method according to Claim 9, **characterized in that** the step of forming the additional layer configured so as to increase the resistivity of the photosensitive layer (3) comprises forming a self-assembled monolayer (6) between the two electrodes (2a, 2b).

11. Method according to either one of Claims 9 and 10, **characterized in that** the step of forming the additional layer configured so as to increase at least locally the conductivity of the photosensitive layer (3) comprises forming a PEDOT:PSS layer (7) on at least a part of the front face (5) of the photosensitive layer (3) opposite a rear face of the photosensitive layer (3) in contact with the electrodes (2a, 2b).

Figure 1

Figure 2

Figure 3

Figure 4

Figure 5

Figure 6

Figure 7

Figure 8

Figure 9

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- DE 102011077961

- US 2007262303 A